Europäisches Patentamt

(19) European Patent Office

Office européen des brevets

(11) Veröffentlichungsnummer: **0 181 429**
**A1**

(12) # EUROPÄISCHE PATENTANMELDUNG

(21) Anmeldenummer: 85105046.8

(51) Int. Cl.⁴: **G 01 R 1/067**

(22) Anmeldetag: 25.04.85

(30) Priorität: 13.11.84 DE 3441480

(43) Veröffentlichungstag der Anmeldung:
21.05.86 Patentblatt 86/21

(84) Benannte Vertragsstaaten:
AT BE CH DE FR GB IT LI LU NL SE

(71) Anmelder: MANIA Elektronik Automatisation
Entwicklung und Gerätebau GmbH
Hauptstrasse 86
D-6384 Schmitten 2(DE)

(72) Erfinder: Driller, Hubert, Dipl.-Phys.
Altkönigstrasse 11
D-6384 Schmitten 3(DE)

(72) Erfinder: Mang, Paul
Wellbergstrasse 4
D-6384 Schmitten 3(DE)

(74) Vertreter: Ruschke, Hans Edvard et al,
Patentanwälte Dipl.-Ing. Olaf Ruschke Dipl.-Ing. Hans E.
Ruschke Dipl,-Ing. Jürgen Rost Dipl.-Chem. Dr. U. Rotter
Pienzenauerstrasse 2
D-8000 München 80(DE)

(54) Kontakststift.

(57) Kontaktstift zur Verwendung in einer elektrischen Prüfvorrichtung für Leiterplatten zum Anschluß eines jeden, an
beliebiger Stelle angeordneten Anschlußpunktes der Leiterplatte an einen der nach einem festen Muster angeordneten
Kontakte der Prüfvorrichtung, mit einem sich verjüngenden
Kopf, dessen Basis einen wesentlich größeren Durchmesser
aufweist als die als Bohrungen ausgebildeten Anschlußpunkte herkömmlicher Leiterplatten, dadurch gekennzeichnet, daß die Spitze des sich verjüngenden Kopfes mit
mindestens einer die Längsmittelachse des Kontaktstiftes
mittig durchsetzenden radial verlaufenden Nut versehen ist,
die mehrere Teilspitzen ausbildet, die auf einem Kreis um die
Längsmittelachse mit einem Durchmesser liegen, der
wesentlich kleiner ist als der Durchmesser der Anschlußbohrung von üblichen Leiterplatten.

Teilspitzen

FIG.3

Kontaktstift

Die vorliegende Erfindung betrifft einen Kontaktstift zur Verwendung in einer elektrischen Prüfvorrichtung für Leiterplatten gemäß Oberbegriff des Patentanspruches 1.

Herkömmliche Kontaktstifte zur Verwendung in einer elektrischen Prüfvorrichtung für Leiterplatten sind üblicherweise als langgestreckte nadelförmige Bauteile gestaltet, die einen möglicherweise vergrößerten, kegelförmigen Kopf aufweisen, der zum Eingriff in die als Bohrungen ausgestalteten Anschlußpunkte von herkömmlichen Leiterplatten vorgesehen ist. Bei derartigen Leiterplatten ergibt sich an der kreisförmigen Kontaktfläche zwischen der Anschlußbohrung der Leiterplatte und dem kegelförmigen Kopf des Kontaktstiftes ein ausreichend starker Kontaktdruck, um eine zuverlässige Kontaktierung zwischen dem Kontaktstift und der zu prüfenden Leiterplatte zu erzeugen.

0181429

- 2 -

Nachdem in neuerer Zeit zunehmend stärker Mehrlagenleiterplatten verwendet werden, bei denen die Anschlußpunkte im Verlauf des Herstellungsprozesses nicht immer als Bohrungen sondern zeitweilig auch als Kontaktflächen vorliegen, muß der Kontakt zwischen dem Kontaktstift und der Kontaktfläche bei Verwendung dieser herkömmlichen Kontaktstifte bisher durch die Spitze des Kopfes des Kontaktstiftes hergestellt werden. Es hat sich jedoch herausgestellt, daß sich hierbei eine nicht mehr zu vernachlässigende Fehlerhäufigkeit bei der Kontaktierung einstellt, was das Meßergebnis bei der Prüfung der Leiterplatten unbrauchbar macht. Dies ist darauf zurückzuführen, daß die Leiterbahnen der Leiterplatten mit einer Oxidschicht überzogen sind, die von der einen, eventuell schon abgenutzten Kontaktspitze durchdrungen werden muß, damit ein ordnungsgemäßer Kontakt hergestellt wird. Zu diesem Zweck muß ein nicht unerheblicher Kontaktdruck gegeben sein, der aber bei den hier in Rede stehenden Prüfvorrichtungen nicht ohne weiteres erhöht werden kann, da der gesamte, auf die Prüfvorrichtung aufzubringende Anpreßdruck ohnehin schon wegen der bisweilen vielen 10.000 Kontaktpunkte sehr groß ist und daher nicht beliebig erhöht werden kann.

Es ist daher die der vorliegenden Erfindung zugrundeliegende Aufgabe, die mit einem sich verjügenden, z.B. kegelförmigen Kopf versehenen Kontaktstifte zur Prüfung herkömmlicher Leiter-

- 3 -

platten mit Anschlußbohrungen derart weiterzubilden, daß sie ohne Erhöhung des Anpreßdruckes der Kontaktstifte zu einer zuverlässigen Kontaktierung auch von solchen Leiterplatten führen, die mit einfachen Lötpunkten oder Kontaktbereichen anstelle von Anschlußbohrungen versehen sind.

Diese Aufgabe wird erfindungsgemäß durch den Patentanspruch 1 gelöst. Indem mehrere einen geringen Abstand voneinander aufweisende, im wesentlichen in einer Ebene liegende Teilspitzen vorgesehen werden, ist die Wahrscheinlichkeit stark erhöht, daß zumindest eine der Spitzen die immer vorhandene Oxidschicht auf der Leiterbahn durchdringt. Dies ist insbesondere deshalb der Fall, weil jede dieser Teilspitzen wesentlich kleiner ist als die sonst vorhandene Spitze des sich verjüngenden Kopfes des Kontaktstiftes und weil auch bei ungünstigen Kontaktverhältnissen etwa aufgrund von einer welligen Oberfläche der Leiterbahnen oder von leicht schrägstehenden Kontaktstiften zu erwarten ist, daß wenigstens eine der Teilspitzen einen guten Kontakt mit dem zu prüfenden Anschlußpunkt herstellt.

In den beigefügten Zeichnungen wird ein Ausführungsbeispiel der vorliegenden Erfindung beschrieben.

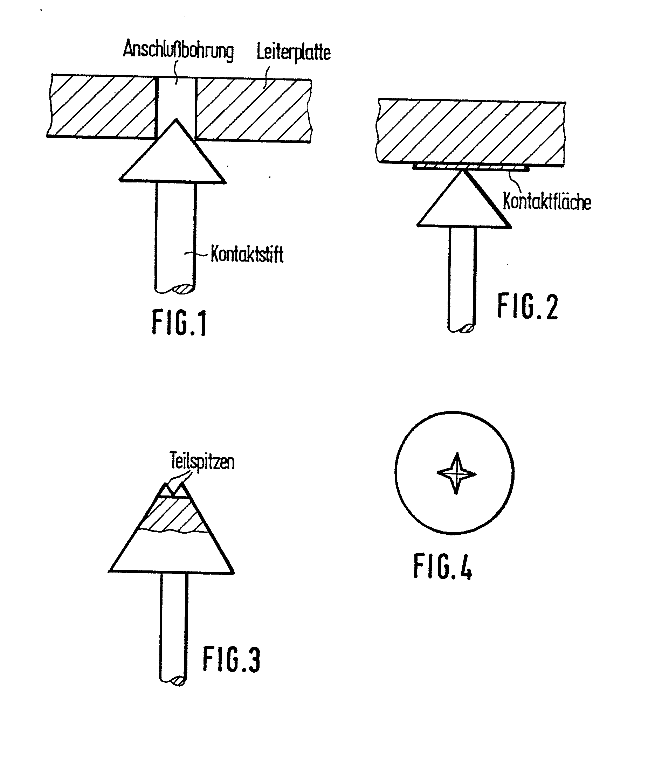

Fig. 1    zeigt den sich verjüngenden,
         z.B. kegelförmigen Kopf eines

- 4 -

üblichen Kontaktstiftes im

Eingriff mit der Anschlußbohrung einer herkömmlichen Leiterplatte;

Fig. 2    zeigt einen solchen Kontaktstift in Anlage an einem Anschlußpunkt beispielsweise einer noch ungebohrten Innenlage einer noch ungebohrten Mehrlagenleiterplatte oder einer Keramikleiterplatte;

Fig. 3    zeigt einen vergrößert dargestellten Mittellängsschnitt durch die Spitze des Kopfes in der erfindungsgemäßen Ausgestaltung; und

Fig. 4    zeigt eine Draufsicht auf die Figur 3.


Bei der Verwendung eines herkömmlichen Kontaktstiftes mit einem sich verjüngenden, z.B. kegelförmigen Kopf gemäß Fig.

1 und 2 dient die Zuspitzung des Kopfes im wesentlichen dazu, den Kontaktstift ohne große Probleme in die Anschlußbohrung der Leiterplatte (Durchmesser ca. 0,7 - 1,5 mm) einzuführen.

Die eigentliche Spitze des sich verjüngenden Kopfes ist dabei von untergeordneter Bedeutung, da die Kontaktierung zwischen der Bohrung des Anschlußpunktes der Leiterplatte und dem Kontaktstift in derjenigen Ebene des Kopfes erfolgt, die dem Durchmesser der Anschlußbohrung entspricht. Durch die wie ein Keil wirkende seitliche Pressung zwischen der Anschlußbohrung und dem kegelförmigen Kopf ergibt sich in der Regel
ein ausreichend guter Kontakt.

Bei den herkömmlichen Kontaktstiften hat die Spitze des sich
verjüngenden Kopfes aufgrund von Herstellungstoleranzen oder
von Abnutzung häufig einen solchen Krümmungsradius, daß nicht
immer mit ausreichender Sicherheit eine gute Kontaktgabe beim
Andrücken auf einen Anschlußpunkt beispielsweise einer nicht gebohrten Leiterplatte erfolgt. In diesem Zusammenhang ist von
Bedeutung, daß die auf einen Kontaktstift entfallende Andruckkraft im Mittel nur 50 - 300 p betragen kann. Um diese Schwierigkeiten zu überwinden, wird erfindungsgemäß in die Spitze
eines jeden Kontaktstiftes mindestens eine Nut eingeschliffen,
also z.B. zwei senkrecht zueinander verlaufende, gegebenenfalls
im Querschnitt V-förmige Nuten, die in einer Radialebene des
kegelförmigen Kopfes verlaufen und die Längsmittelachse desselben mittig durchsetzen. Indem in die Spitze eines Kontaktstiftes beispielsweise mit Hilfe von geeigneten Diamantschleifscheiben mehrere einander kreuzende Nuten eingeschliffen werden,
entstehen entsprechend viele auf einem Kreis in einer Radialebene liegende Teilspitzen, durch die die Chance erhöht wird,
daß wenigstens eine davon die isolierende Oxidschicht auf der
Leiterbahn durchdringt. Es entsteht also ein mit einer herkömmlichen, sich verjüngenden Spitze versehener Kontaktstift,
der zum Prüfen von Leiterplatten mit Anschlußbohrungen geeignet ist, der aber darüber hinaus auch zum Kontaktieren von ungebohrten Anschlußflächen geeignet ist, wie sie bei Keramikleiterplatten oder bei der Herstellung von Mehrlagenleiterplatten auftreten, deren Innenlagen zunächst als ungebohrte Leiterplatten erstellt werden, die dann vor dem Zusammenkleben mit anderen Leiterplatten und vor dem Bohren der Anschlußbohrungen ebenfalls auf ordnungsgemäße Funktion geprüft werden müssen. Gerade bei dem letztgenannten Anwendungsfall sind die erfindungsgemäßen Kontaktstifte von besonderem Vorteil, weil auf einem Prüfadapter aus solchen Kontaktstiften gebohrte und ungebohrte Leiterplatten mit der gleichen Verteilung der Kontaktbereiche geprüft werden können, ohne daß es einer Umrüstung des Prüfadapters von der einen Art Kontaktstifte zur Prüfung von Anschlußbohrungen auf die andere Art Kontaktstifte zur Prüfung von Kontaktflächen bedarf. Dies führt insbesondere bei der Herstellung und Prüfung von Mehrlagenleiterplatten zu wesentlichen Einsparungen an Investitions- und Arbeitszeitkosten, weil sowohl die zunächst noch ungebohrten innenliegenden Leiterplatten als auch die daraus zusammengestellte fertiggestellte und mit durchgehenden Anschlußbohrungen versehene Mehrlagenleiterplatte mit demselben Prüfadapter geprüft werden können.

**MÜNCHEN**
Pienzenauerstraße 2
8000 München 80
Telefon (089) 98 03 24,
98 72 58, 98 88 00
Telecopy Gr II (089) 222 066
Kabel: Quadratur München
Telex: 522 767 rush d

**BERLIN**
Kurfürstendamm 182/183
1000 Berlin 15
Telefon (030) 8 83 70 78/79
Kabel: Quadratur Berlin

## RUSCHKE & PARTNER
## ANWALTSSOZIETÄT

München, den 24.4.1985

Dr.-Ing. Hans Ruschke 0 181 429 -1980
Dipl.-Ing. Hans E. Ruschke
Dipl.-Ing. Olaf Ruschke*
Dipl.-Ing. Jürgen Rost
Dipl.-Chem. Dr Ulrich Rotter
Patentanwälte
Zugelassen beim Europäischen Patentamt
Admitted to the European Patent Office
* in Berlin

Rainer Schulenberg
Rechtsanwalt
Zugelassen bei den LG München I und II
beim OLG München und dem
Bayer. Obersten Landesgericht

M 4446 HO

MANIA ELEKTRONIK AUTOMATISATION ENTWICKLUNG UND GERÄTEBAU GmbH

Hauptstr. 86, 6384 Schmitten 2

------------------------------------------------------------

P a t e n t a n s p r ü c h e

1. Kontaktstift zur Verwendung in einer elektrischen Prüfvorrichtung für Leiterplatten zum Anschluß eines jeden, an beliebiger Stelle angeordneten Anschlußpunktes der Leiterplatte
an einen der nach einem festen Muster angeordneten Kontakte
der Prüfvorrichtung, mit einem sich verjüngenden Kopf, dessen
Basis einen wesentlich größeren Durchmesser aufweist als die
als Bohrungen ausgebildeten Anschlußpunkte herkömmlicher Leiterplatten, dadurch gekennzeichnet, daß die Spitze des sich
verjüngenden Kopfes mit mindestens einer die Längsmittelachse
des Kontaktstiftes mittig durchsetzenden radial verlaufenden
Nut versehen ist, die mehrere Teilspitzen ausbildet, die auf einem Kreis um die Längsmittelachse mit einem Durchmesser liegen, der wesentlich kleiner ist als der Durchmesser der Anschlußbohrungen von üblichen Leiterplatten.

2. Kontaktstift nach Anspruch 1, dadurch gekennzeichnet, daß
zwei senkrecht zueinander verlaufende Nuten vorgesehen sind, die
vier in einer Radialebene liegende Teilspitzen ausbilden.

3. Kontaktstift nach Anspruch 1 oder 2, dadurch gekennzeichnet, daß die Nuten V-förmig sind.

4. Kontaktstift nach einem der Ansprüche 1 bis 3, dadurch
gekennzeichnet, daß die Teilspitzen auf einen Kreis mit einem
Durchmesser von 0,5 mm oder weniger liegen.

Anschlußbohrung   Leiterplatte

Kontaktstift

**FIG.1**

Kontaktfläche

**FIG.2**

Teilspitzen

**FIG.3**

**FIG.4**

**0181429**
Nummer der Anmeldung

Europäisches
Patentamt

**EUROPÄISCHER RECHERCHENBERICHT**

EP  85 10 5046

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int CI 4) |
|---|---|---|---|
| X | DE-B-1 765 461  (A. BOSSERT) <br> * Anspruch 8, Spalte 4, Zeilen 56-65; Figuren 4, 5 * | 1-3 | G 01 R   1/067 |
| X | DE-A-2 852 886  (FEINMETALL GMBH) <br> * Ansprüche 1-8, Figuren 1-3 * | 1-3 | |
| A | DE-A-3 300 247  (TECHNOBAL S.A.) <br><br> * Figur 2 * | | |
| A | DE-A-3 038 937  (TERADYNE INC.) <br><br> * Figur 1 * | | |
| A | DE-B-2 757 717  (TERADYNE INC.) <br><br> * Figur 2 * | | RECHERCHIERTE SACHGEBIETE (Int. CI 4) |
| A | US-A-4 417 206  (J.P. STOWERS) <br><br> * Figur 1 * | | G 01 R   1/067 <br> G 01 R   1/073 <br> H 01 R  11/18 |
| A | US-A-4 322 682  (K.H. SCHADWILL) <br><br> * Figuren 8-11 * | | |
| A | US-A-4 307 928  (W. PETLOCK) <br><br> * Figuren 5-8 * | | |

Der vorliegende Recherchenbericht wurde für alle Patentansprüche erstellt

| Recherchenort BERLIN | Abschlußdatum der Recherche 30-08-1985 | Prüfer LEMMERICH J |
|---|---|---|